# EUROPÄISCHE PATENTSCHRIFT

(11) **EP 2 290 766 B1**
(45) Veröffentlichungstag und Bekanntmachung des Hinweises auf die Patenterteilung: **03.04.2019**
(21) Anmeldenummer: 10173278.2
(22) Anmeldetag: 18.08.2010
(51) Int. Cl.: H01S 5/028, H01S 5/02, H01S 5/00

(54) **Hochleistungs-Diodenlaser und Verfahren zum Herstellen eines Hochleistungs-Diodenlasers**
High performance diode laser and method of producing the same
Laser à diodes haute puissance et son procédé de fabrication

(30) Priorität: 28.08.2009 DE 102009028985; 17.12.2009 DE 102009054912
(43) Veröffentlichungstag der Anmeldung: 02.03.2011
(73) Patentinhaber: m2k-laser GmbH, 79108 Freiburg (DE)
(72) Erfinder: Kelemen, Marc, 79194 Gundelfingen (DE); Moritz, Rudolf, 79211 Denzlingen (DE); Gilly, Jürgen, 79194 Gundelfingen (DE); Friedmann, Patrick, 79263 Simonswald (DE)
(74) Vertreter: Meissner Bolte Partnerschaft mbB

(56) Entgegenhaltungen:
- EP-A2- 0 637 862
- JP-A- H0 432 285
- JP-A- 359 055 077
- US-A- 4 337 443
- US-B1- 6 396 864
- US-B1- 6 618 409

## Beschreibung

Die Erfindung betrifft einen Hochleistungs-Diodenlaser und ein Verfahren zum Herstellen eines Hochleistungs-Diodenlasers.

Hochleistungs-Diodenlaser d.h. Diodenlaser mit hohen Leistungsdichten auf der Basis von III-V-Halbleiterschichten wie (Al,In)GaAs, (Al,In)InP und (Al,In)GaSb finden vielfältige Anwendungen in unterschiedlichsten Gebieten wie etwa dem Pumpen von Festkörper-, Faser- und Scheibenlasern, der direkten Materialbearbeitung mittels Diodenlasermodulen und der medizinischen Therapie und Diagnostik. Als Hochleistungs-Diodenlaser werden im Folgenden Diodenlaser mit einer optischen Leistungsdichte von mehr als 40mW pro Mikrometer Facettenbreite definiert. Als Facetten werden im Folgenden die beiden gegenüberliegenden Lichtaustrittsflächen eines Diodenlasers bezeichnet.

Bei der heutzutage hohen Qualität der III-V-Halbleiterschichten sind sowohl die Lebensdauer als auch die maximal mögliche optische Ausgangsleistung von Hochleistungs-Diodenlasern vor allem durch die Qualität ihrer Facetten begrenzt. Ausgangsprodukt bei der Herstellung von Hochleistungs-Diodenlasern sind Wafer, die eine Vielzahl von Laserdioden enthalten. Zum Vereinzeln der Laserdioden bzw. Laserdiodenarrays oder Diodenlaserbarren werden die Wafer gebrochen, wobei auf Bruchstellen bzw. Spaltflächen jeweils Schichtsysteme aufgebracht werden, die die Facetten des Hochleistungs-Diodenlasers bilden. Insbesondere beim Brechen von Wafern an Luft entsteht an der Spaltfläche ein Gemisch verschiedener Halbleiteroxide. Diese Oxidschicht ist durch die hohe Dichte an Grenzflächenzuständen Ursache eines hohen Anteils an nichtstrahlender Rekombination, so dass im Betrieb des Hochleistungs-Diodenlasers im Bereich der Facette eine lokale Aufheizung stattfindet. Mit dieser Aufheizung ist eine Verringerung der Bandlücke verknüpft. Diese führt ihrerseits zu einer weiteren Aufheizung im Bereich der Facette und damit zu einer in sehr kurzer Zeit zunehmenden Verringerung der Bandlücke, so dass sich der Hochleistungs-Diodenlaser im Bereich der Facette und damit auch die Facette selbst immer stärker aufheizt. Die Facette wird dadurch innerhalb einer sehr kurzen Zeit im Wesentlichen thermisch zerstört. Dieser Prozess limitiert die maximal mögliche optische Ausgangsleistung von Hochleistungs-Diodenlasern.

Die Oxide sind außerdem chemisch instabil bezüglich der Halbleitermaterialien, so dass sich die Aufheizung der Facette verursachende Gitterdefekte in das Innere des Halbleiters ausbreiten. Die genannten Effekte führen zu zwei wesentlichen Einschränkungen für die Lebensdauer der Halbleiterbauteile. Zum einen erhält man eine kontinuierliche Degradation, die durch einen kontinuierlichen Anstieg des Betriebsstromes gekennzeichnet ist, der für eine konstante Ausgangsleistung nötig ist. Zum anderen sinkt aufgrund der Degradation des Halbleitermaterials die Schwelle für den Betriebsstrom, oberhalb der eine plötzliche Zerstörung der Spiegelflächen und damit ein spontaner Ausfall des Hochleistungs-Diodenlasers (genannt COD, Catastrophic Optical Damage) eintritt, so dass die bei einem Betrieb unterhalb der COD-Schwelle maximal mögliche optische Ausgangsleistung des Hochleistungs-Diodenlasers im Laufe der Betriebsdauer abnimmt.

Um das Ausmaß der Degradation des Halbleitermaterials und der dadurch verursachten Absenkung der COD-Schwelle zu verringern, ist es bei der Herstellung von Hochleistungs-Diodenlasern bekannt, Spaltflächen zu erzeugen, die keinen Sauerstoff enthalten und frei von Stoffen sind, die mit den Halbleitermaterialien im Bereich der Spaltflächen reagieren können. Dies geschieht entweder dadurch, dass der Wafer in sauerstofffreier Atmosphäre gebrochen wird, oder dass nach dem Brechen in Luft eine Behandlung der Spaltfläche erfolgt, bei der diese gereinigt wird, d.h. der in der Spaltfläche enthaltene Sauerstoff entfernt oder gebunden wird, so dass er chemisch weniger reaktiv ist.

Anschließend muss dafür Sorge getragen werden, die sauerstofffreie bzw. Sauerstoff nur in einer gebundenen (oxidischen) Form enthaltende Spaltfläche weiterhin von unkontrolliert reagierendem Sauerstoff frei zu halten. Dazu muss die gereinigte Spaltfläche durch eine Schutzschicht, im Folgenden als Passivierungsschicht bezeichnet, verkapselt werden. Anschließend werden zur Einstellung der gewünschten Reflektivität des Hochleistungs-Diodenlasers weitere optische, die Reflektivität bestimmende Funktionsschichten aufgebracht.

In der US 5,063,173, der US 5,144,634 und der US 5,171,717 wird als effektive Methode zur Erzeugung oxidfreier Spaltflächen die Vermeidung des Kontaktes mit Luft beschrieben. Dies geschieht durch Vereinzeln eines Wafers in Diodenlaserarrays im Ultrahochvakuum bei einem Druck, der kleiner als 10⁻⁸ mbar ist. Anschließend wird in-situ durch Elektronenstrahl-Aufdampfen eine dünne Passivierungsschicht von etwa 20nm wahlweise bestehend aus den Materialien Si, Ge oder Sb aufgebracht.

In der US 4,563,368 wird eine Passivierungsschicht für an Luft gespaltene Hochleistungs-Diodenlaser beschrieben, bestehend aus reaktivem Material wie Al, Si, Ta, V, Sb, Mn, Cr oder Ti, aufgetragen durch Ionenstrahlsputtern unter Argon bei 8x10⁻⁵ mbar. Si kann dabei entweder in Wasserstoffumgebung oder als Silanverbindung aufgebracht werden. Danach können in derselben Probenkammer eine oder mehrere Schichten zur Einstellung der Reflektivität, bestehend aus den Materialien Si, Si0₂ und AI₂0₃ gesputtert werden.

In der US 6,618,409 B1 wird ein Passivierungskonzept für an Luft gebrochene Laserdiodenarrays beschrieben, das auf einem Mehrschrittprozess in einer Vakuumanlage mit insgesamt drei getrennten Prozesskammern basiert. Es ist dadurch gekennzeichnet, dass die Facetten unter Ultrahochvakuum von 3x10⁻¹⁰ bis 1x10⁻⁷ mbar unter Verwendung entweder einer H₂/Ar oder H₂//Xe Ionenkanone oder eines Wasserstoff-ECR (electron cyclotron resonance)-Plasmas mit reinem H₂ oder Ar/H₂ bzw. Xe/H₂ Gemischen als Gasquelle mit einer kinetischen Energie zwischen 1eV und 24eV gereinigt werden. Die Prozesstemperatur beim Entfernen (Reduzieren) der Oxidschicht beträgt unter 200°C. Anschließend wird hydrogenisiertes amorphes Silicium (a-Si:H) als Passivierungsschicht mit einer Dicke von etwa 20nm aufgesputtert, ebenfalls bei einer Prozesstemperatur unter 200°C. Nach Abschluss der Passivierung werden eine oder mehrere Funktionsschichten zur Einstellung der Reflektivität mittels Ionenstrahl-Sputtern in zwei weiteren Prozesskammern aufgebracht, wobei als Material für die hochreflektierenden Schichten SiO₂ und Nb₂O und als Material für die niedrigreflektierenden Schichten Nb₂O₅ verwendet wird.

Aus der DE 102 21 952 A1 ist ein Passivierungskonzept für an Luft gebrochene Laserdiodenarrays bekannt, das auf einem Mehrschrittprozess in zwei getrennten Vakuumanlagen basiert. Die Laserdiodenarrays werden auf eine Temperatur zwischen 350°C und 420°C erwärmt und unter Ultrahochvakuum von 1x10⁻⁸ bis 1x10⁻⁷ mbar unter Verwendung von atomarem oder angeregtem molekularen Wasserstoff als reaktives Medium mit einer kinetischen Energie kleiner als 2eV gereinigt. Anschließend wird eine Schutzschicht aus einem der Materialien ZnSe, Gd₂0₃, Si oder BeTe als Passivierung aufgedampft. Nach Abschluss der Passivierung werden eine oder mehrere Funktionsschichten zur Einstellung der Reflektivität aus einem oder mehreren der Materialien Al₂0₃, Ti0₂, Si0₂, Ta₂0₅ oder Si mittels Ionenstrahl-Sputtern in einer zweiten Vakuumapparatur aufgebracht.

In der US 4,337,443 A wird ein Diodenlaser mit 5-10mW optischer Leistung pro Mikrometer Facettenbreite beschrieben, der ein mittels Sputteranlagen aufgebrachtes Material der Zusammensetzung (Si₁₋ₛ₋ₜGeₛCₜ)₁₋ₓHₓ als Passivierungsschicht enthält. Die Schichtdicken sind gemäß m(λ/4) (m=1,3,5...) zu wählen, wobei λ die Wellenlänge in dem aufgebrachten Material darstellt. Diese Passivierungsschicht muss wiederum durch eine transparente Isolationsschicht aus SiO₂, Al₂O₃, MgO, ZnO, TiO₂ oder Si₃N₄ der Dicke λ/2 gegen die Umgebung geschützt werden.

In der JP 04-032,285 A wird ebenfalls eine mittels Sputteranlagen aufgebrachte Passivierungsschicht aus SiC der Schichtdicke λ/2 erwähnt.

In der US 5,780,120 wird eine Facettenbehandlung im Ultrahochvakuum mittels eines PLD-Verfahrens (pulsed laser deposition) behandelt. Die Laserbarren wurden dabei unter Sauerstoffausschluß, beispielsweise in einer Stickstoffatmosphäre, gebrochen. Die Reinigung der Facetten erfolgt dabei mittels gepulster Laserstrahlung der Energie 70-120 mJ/cm². Nach der Reinigung erfolgt eine weitere Nachreinigung unter Br oder Cl. Danach wird mittels Laserabtrag eine Passivierungsschicht aus Si oder GaN einer Dicke bis 2nm aufgebracht. Abschließend erfolgt wiederum mittels PLD mit Energien von 1-5 J/cm² aus Feststoff-SiC die Abscheidung einer SiC-Schicht.

In der US 2003/0048823 A1 wird über ein mittels Sputteranlagen auf den Facetten eines Diodenlasers aufgebrachtes Schichtsystem bestehend aus einer Passivierungsschicht und einer reflexionsbestimmenden Schicht. Während die Passivierungsschicht aus Si oder wahlweise SiC der Dicke 1nm besteht, muss die reflexionsbestimmende Schicht aus einer nitridhaltigen Schicht bestehen, beispielsweise Si₃N₄.

US 6396864 B1 offenbart einen Diodenlaser mit gegenüberliegenden Facetten, die jeweils mit einer SiC Schicht und einer weiteren Schicht beschichtet sind. Das Schichtensystem übernimmt die Funktion sowohl einer Passivierungsschicht, als auch einer reflektierenden Schicht.

Alle genannten Verfahren führen zu einer Verbesserung der Langzeitstabilität und der maximal möglichen Ausgangsleistung von Diodenlasern im Vergleich zu Diodenlasern, die ohne das Aufbringen eines Schichtsystems (mit oder ohne vorheriges Reinigen) gefertigt worden sind.
Die beschriebenen Verfahren sind jedoch sehr aufwendig, da die Facetten der einzelnen Hochleistungs-Diodenlaser bzw. Diodenlaserarrays entweder unter Sauerstoffausschluss gebrochen werden müssen, oder nach einem Brechen an Luft gereinigt und anschließend mit einer Passivierungsschicht versehen werden müssen, auf die anschließend hochreflektierende bzw. niedrigreflektierende Funktionsschichten aus von der Passivierungsschicht unterschiedlichen Materialien aufgebracht werden. Bei den bekannten Verfahren werden für die hochreflektierenden Funktionsschichten stets sauerstoffhaltige chemisch stabile Verbindungen wie Si0₂, Al₂0₃ oder Ti0₂ verwendet. Niedrigbrechende Funktionsschichten enthalten meist stickstoffhaltige Verbindungen wie Si₃N₄. In der Praxis muss deshalb die Reinigung der gebrochenen Halbleiterflächen, die Herstellung der Passivierungsschichten und zumindest der hochreflektierenden Funktionsschichten in jeweils getrennten Vakuumkammern mit entsprechend hohem fertigungstechnischem Aufwand erfolgen, um eine unkontrollierte Kontamination der Halbleitergrenzflächen und der Passivierungsschichten mit Sauerstoff zu vermeiden.

Das in den meisten Verfahren benötigte Ultrahochvakuum während der Prozesse führt zu weiteren Anforderungen an die verwendeten Anlagen.

Die in den bekannten Verfahren zur Abscheidung von Schichten aus Feststoffquellen oft verwendete Sputtertechnologie kann bei den in dieser Erfindung beschriebenen Hochleistungs-Diodenlasern aufgrund der zu hohen Schädigung der Halbleitergrenzflächen und der daraus folgenden starken zeitlichen Abnahme der COD-Schwelle nicht eingesetzt werden.

Der Erfindung liegt nun die Aufgabe zugrunde, einen Hochleistungs-Diodenlaser mit hoher COD-Schwelle bei zugleich hoher Standzeit anzugeben. Außerdem liegt der Erfindung die Aufgabe zugrunde, ein Verfahren zu seiner Herstellung anzugeben.

Hinsichtlich des Hochleistungs-Diodenlasers wird die genannte Aufgabe gemäß der Erfindung mit den Merkmalen des Patentanspruches 1 gelöst. Gemäß diesen Merkmalen sind alle Schichten der die Facetten bildenden Schichtsysteme jeweils aus Silicium und Kohlenstoff zusammengesetzt und basieren damit auf nur einem Materialsystem, das sauerstofffrei ist. Dabei erfüllen die amorphen Schichtsysteme sowohl die Anforderungen an eine Passivierungsschicht nach der Reinigung der Halbleiterspaltflächen als auch an die die Reflexion bestimmenden Funktionsschichten, d.h. diese Schichtsysteme dienen als Ver- und Entspiegelung der Laserfacetten. Ein solcher Hochleistungs-Diodenlaser weist eine hohe COD-Schwelle bei zugleich hoher Standzeit auf. Ursache hierfür ist die mittels des Mengenverhältnisses von Silicium und Kohlenstoff einfach einstellbare Reflektivität und auch deren Variation innerhalb eines Schichtsystems. Zudem bietet die hohe Wärmeleitfähigkeit eines aus Silicium und Kohlenstoff zusammengesetzten Schichtsystemes, die höher ist, als die Wärmeleitfähigkeit aller im Stand der Technik verwendeten Passivierungs- und Funktionsschichten, Vorteile bezüglich der Spreizung der Wärme und damit der Kühlung der Facetten. Die Wärmeleitfähigkeit von SiC ist beispielsweise einen Faktor 10 höher als die Wärmeleitfähigkeit von Si₃N₄.

Der Begriff "zusammengesetzt" ist dabei dahingehend zu verstehen, dass weitere prozesstechnisch unvermeidbare Bestandteile, beispielsweise Wasserstoff, in geringen Konzentrationen enthalten sein können.

Alle Schichten der die Facetten bildenden Schichtsysteme basieren auf nur einem sauerstofffreien Materialsystem, das deren Herstellung in Abwesenheit von Sauerstoff in nur einer Prozesskammer ermöglicht. So können für die Durchführung aller Fertigungsprozesse kostengünstige PECVD (plasma enhanced chemical vapour deposition)- Anlagen aus der Si-Technologie eingesetzt werden, wobei nur eine Anlage mit nur einer Prozesskammer für Reinigung und Beschichtung benötigt wird, und für die Durchführung des Verfahrens in der Prozesskammer höchstens ein Hochvakuum, nicht jedoch ein Ultrahochvakuum erforderlich ist. Dadurch ist der fertigungstechnische und apparative Aufwand signifikant reduziert. Zudem können die für Hochleistungs-Diodenlaser aufgrund der zu großen Schädigung des Halbleiters nicht einsetzbaren Sputteranlagen durch ein deutlich weniger schädigendes Abscheideverfahren ersetzt werden.

Dagegen müssen bei allen derzeit zur Beschichtung von Hochleistungs-Diodenlasern eingesetzten Verfahren entweder Anlagen mit mindestens zwei integrierten Prozesskammern und einer Handhabungsvorrichtung, mit der es möglich ist, das zu bearbeitende Substrat von einer in die andere Prozesskammer umzusetzen, oder mindestens zwei separate Anlagen mit jeweils einer Prozesskammer eingesetzt werden. Dementsprechend reduzieren sich bei dem Verfahren gemäß der Erfindung die Anlagenkosten im Vergleich zu den im Stand der Technik eingesetzten Verfahren um ca. 50%.

Hinsichtlich des Verfahrens wird die genannte Aufgabe gemäß der Erfindung mit den Merkmalen des Patentanspruches 2 gelöst, dessen Merkmale sinngemäß den Merkmalen des Patentanspruches 1 entsprechen.

Weitere vorteilhafte Ausgestaltungen des Verfahrens sind in den Patentanspruch 2 nachgeordneten Unteransprüchen angegeben.

Zur weiteren Erläuterung der Erfindung wird auf die in der Zeichnung wiedergegebenen Ausführungsbeispiele verwiesen. Es zeigen:
- Fig. 1: den Aufbau eines Hochleistungs-Diodenlasers mit einem Schichtsystem auf beiden Seiten, das jeweils aus einer Passivierungsschicht und die Reflexion bestimmenden Funktionsschichten gemäß der vorliegenden Erfindung in einer vereinfachten Prinzipdarstellung,
- Fig. 2: ein Diagramm, in dem die Ausgangsleistung gegen den Betriebsstrom unter verschiedenen Betriebsbedingungen für unterschiedlich hergestellte HochleistungsDiodenlaser aufgetragen.
- Fig. 3: ein Diagramm, in dem ebenfalls die Ausgangsleistung gegen den Betriebsstrom unter gepulsten Betriebsbedingungen für unterschiedlich hergestellte Hochleistungs-Diodenlaser aufgetragen ist.
- Fig. 4,5: jeweils ein Diagramm, in dem die optische Ausgangsleistung bei konstantem Betriebsstrom gegen die Betriebsdauer für einen Hochleistungs-Diodenlaser, dessen Facetten gemäß dem Stand der Technik hergestellt worden sind, bzw. für einen HochleistungsDiodenlaser, der gemäß der vorliegenden Erfindung hergestellt worden ist, aufgetragen ist.

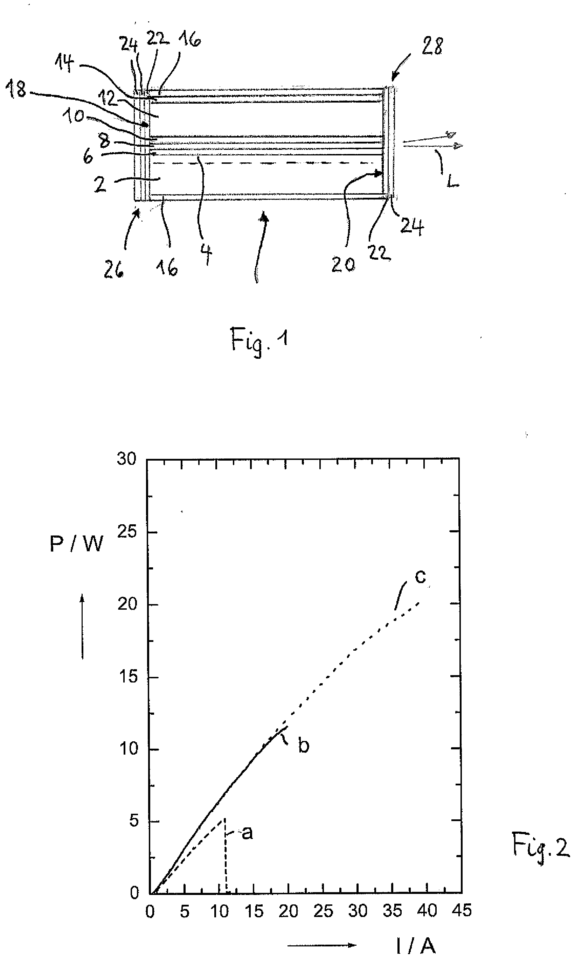

Im Ausführungsbeispiel gemäß Fig.1 ist schematisch ein auf der Basis von GaAs-Substraten hergestellter Hochleistungs-Diodenlaser dargestellt. Ebenso können Diodenlaser auf Basis von anderen III-V Halbleitermaterialien, beispielsweise auf der Basis von InP- oder GaSb-Substraten hergestellt werden.

Bei dem auf der Basis eines GaAs-Substrat hergestellten Hochleistungs-Diodenlaser werden auf einem n-GaAs-Substrat 2 nachfolgend eine n-dotierte Mantelschicht 4 (z.B. AlGaAs, InGaAsP, AlGaAsSb), eine n-seitige Wellenleiterschicht 6 (z.B. AlGaAs, InGaAsP, AlGaAsSb), eine Quantentopfstruktur 8 (z.B. InGaAs, InGaAsP, GaInSb, GaInAsSb), in der die das Laserlicht erzeugenden Rekombinationsprozesse stattfinden, eine p-seitige Wellenleiterstruktur 10, eine p-dotierte Mantelschicht 12 und eine p-dotierte Kontaktschicht 14 (z.B. GaAs, GaSb, InP, InGaAs) abgeschieden.

Durch Ätzen der Kontaktschicht 14 werden Kontaktstreifen zur Strominjektion definiert, deren Breite beispielsweise zwischen 90pm und 100µm beträgt. Durch die Breite der Kontaktstreifen wird dadurch die Ausdehnung der optischen Welle in lateraler Richtung, d.h. senkrecht zur Zeichenebene, definiert. Eine Isolationsschicht 16 sowie in der Figur nicht dargestellte p-seitige und n-seitige Metallisierungsfolgen zur elektrischen Kontaktierung komplettieren den Gesamtschichtaufbau.

Die mit den genannten Halbleiterschichten versehenen und strukturierten Wafer werden durch Anritzen und Spalten an Luft in einzelne Diodenlaserbarren aufgeteilt, die wiederum aus mehreren Hochleistungs-Diodenlasern bestehen.

Einander gegenüberliegende, senkrecht zum Schichtaufbau orientierte Stirnseiten bilden die sogenannten Spaltflächen 18,20. Da auf an Luft erzeugten Spaltflächen 18,20 sofort eine Schicht aus Halbleiteroxiden und Verunreinigungen wie Wasser und Gas-Adsorbate entstehen, welche die maximal mögliche Ausgangsleistung und die Lebensdauer der Hochleistungs-Diodenlaser begrenzen, ist gemäß vorliegender Erfindung eine Reinigung der Spaltflächen 18,20 und deren anschließende Verkapselung mittels einem aus Silizium und Kohlenstoff bestehendem Schichtsystem vorgesehen.

Dazu werden die Diodenlaserbarren in einem Halter so angeordnet, dass beide Spaltflächen 18,20 zugänglich sind. Der Halter wird in eine evakuierbare Prozesskammer eines PECVD oder thermischen CVD Systems eingebracht. Mittels eines in Abwesenheit von Sauerstoff stattfindenden chemischen Plasmaverfahrens werden anschließend die oxidbehafteten Spaltflächen 18,20 gereinigt und reduziert, wobei die Energie der Ionen im Plasma kleiner als 20eV ist. Als Prozessgase für die Reinigung werden Formiergase wie beispielsweise Argon- und/oder Wasserstoffgas verwendet.

Die Effizienz der Reinigung ist dabei bedingt durch eine optimale Wahl der Prozessparameter für Temperatur und Druck. Die Reinigungstemperatur sollte so hoch wie möglich sein. Eine typische Reinigungstemperatur beträgt im Ausführungsbeispiel etwa 400°C und ist zu höheren Temperaturen durch die Legierungstemperaturen bzw. die Schädigung der p- und n-Metallisierungsfolgen begrenzt. Der Basisdruck in der Prozesskammer muss nicht im UHV-Bereich liegen, sondern kann im Bereich 1 x 10⁻¹ bis 1 x 10⁻² mbar liegen.

Anschließend werden die gereinigten Spaltflächen 18,20 in situ, d.h. in derselben Prozesskammer vor erneuter Oxidation oder Verunreinigung geschützt. Dies geschieht durch Aufbringen einer Passivierungsschicht 22, die inert ist bezüglich der benachbarten Halbleitermaterialien und vorzugsweise eventuell noch vorhandene Oxidschichten chemisch stabil bindet. Die Passivierungsschicht 22 dient außerdem dazu, einen erneuten Kontakt der Halbleiterschichten mit Sauerstoff und anderen Verunreinigungen, die von außerhalb über Diffusion eindringen können, zu verhindern.

Die Passivierungsschicht 22 wirkt einerseits als Diffusionsbarriere und ist andererseits aber noch durchlässig für das innerhalb der Quantentopfstruktur 8 erzeugte Laserlicht. Die Passivierungsschicht 22 ist elektrisch isolierend oder zumindest hochohmig, so dass im Betrieb nur vernachlässigbare Anteile des Stromes über die Spaltflächen 18,20 fließen.

Die Passivierungsschicht 22 besteht aus einer aus Silicium und Kohlenstoff bestehenden amorphen Schicht. Diese wird mittels chemischer Gasphasenabscheidung (CVD), vorzugsweise thermischer CVD, insbesondere mittels plasmaunterstützter chemischer Gasphasenabscheidung (PECVD) abgeschieden. Mit solchen Beschichtungsverfahren ist eine Beschädigung der gespaltenen Halbleitergrenzschichten beim Aufbringen der Schichtsysteme weitgehend vermieden.

Für die Abscheidung werden als Prozessgase vorzugsweise Methan (CH₄) und Silan (SiH₄) verwendet. Über die Gasflüsse der Prozessgase und auch durch weitere Prozessparameter wie Druck, Temperatur und Abscheidedauer können die Zusammensetzung der Passivierungsschicht 22 und damit deren Eigenschaften eingestellt werden.

Im Ausführungsbeispiel wird bei identischen Basisdrücken zur Reinigungsphase eine 5nm bis 50nm dicke aus Silicium und Kohlenstoff bestehende amorphe Schicht abgeschieden, deren Siliciumanteil größer ist als der Kohlenstoffanteil. Die Abscheidedauer bewegt sich vorzugsweise in der gleichen Größenordnung wie die Reinigungsdauer und liegt im Bereich zwischen 10 Sekunden und mehreren Minuten. Die Prozesskammer wird zur Abscheidung vorzugsweise auf einer Temperatur zwischen 200°C und 300°C gehalten.

Danach werden auf die beiden Passivierungsschichten 22 Funktionsschichten 24 aufgebracht, mit denen die Reflektivität der jeweiligen Spaltfläche 18,20 eingestellt wird. Diese je nach gewünschter Reflektivität niedrig- bzw. hochreflektierenden Funktionsschichten 24 bestehen ebenfalls aus Silicium und Kohlenstoff, und können, da sie auf demselben Materialsystem wie die Passivierungsschichten 22 basieren, in derselben Prozesskammer aufgebracht werden.

Zur Entspiegelung wird auf eine der jeweils mit der Passivierungsschicht 22 versehenen Spaltflächen 19, 20, im dargestellten Ausführungsbeispiel auf die Spaltfläche 20, eine einzige amorphe, aus Silicium und Kohlenstoff bestehende niedrigbrechende Funktionsschicht 24 abgeschieden. Im Ausführungsbeispiel dieser Erfindung wurde als Brechungsindex 1.99 eingestellt. Diese hat gegenüber einer im Stand der Technik häufig verwendeten, aus Silicium und Stickstoff aufgebauten Si/N-Funktionsschicht zudem den Vorteil, chemisch und thermisch stabiler zu sein. Die Schichtdicke dieser Funktionsschicht 24 beträgt ein Viertel der Zielwellenlänge λ des emittierten Laserlichts L geteilt durch den Brechungsindex (im Anwendungsbeispiel 1.99).

Das hochreflektierende, auf die gegenüberliegende mit der Passivierungsschicht 22 versehene Spaltfläche 18 aufgebrachte Schichtsystem mit >90% Reflektivität besteht aus einem aus mehreren, jeweils aus Silicium und Kohlenstoff bestehenden Funktionsschichten 24 aufgebauten amorphen Schichtsystem, wobei der hohe Reflektionsgrad durch einen möglichst großen Unterschied im Brechungsindex benachbarter Funktionsschichten 24 eingestellt wird. Über die Schichtdicken der einzelnen Funktionsschichten 24 wird der reflektierende Wellenlängenbereich zwischen 600nm und 3000nm eingestellt.

Die Brechungsindices der einzelnen Passivierungs- und Funktionsschichten werden über eine Variation des Kohlenstoffgehaltes während des Abscheidens des Schichtsystemes eingestellt. Bei einem Kohlenstoffgehalt von 5 Atom-% beträgt der Brechungsindex 3,6. Bei einem Kohlenstoffgehalt von 95 At.-% beträgt er etwa 1,7. Grundsätzlich können die Brechungsindices der Funktionsschichten 24 zwischen 1,4 und 3,8 liegen.

Für ein hochreflektierendes Schichtsystem sind somit alternierende Funktionsschichten 24 mit den Brechungsindex-Grenzwerten 1,4 und 3,8 bevorzugt. Jede dieser Funktionsschichten weist vorzugsweise eine Dicke von einem Viertel der zu reflektierenden Wellenlänge auf. Die Schichtdicken betragen damit zwischen 125nm und 750nm.

Die auf die Spaltflächen 18, 28 aus Passivierungsschicht 22 und Funktionsschichten 24 bestehenden als Schichtsysteme 26 bzw. 28 bilden die Facetten des fertiggestellen Hochleistungs-Diodenlasers.

### Ausführungsbeispiel 1 (Vorprodukt)

Als Vorprodukt für die Herstellung eines Hochleistungs-Diodenlasers gemäß der Erfindung wurden Breitstreifen-Hochleistungs-Diodenlaser hergestellt, deren Spaltflächen wie vorstehend erläutert gereinigt und nur mit einer aus Silicium und Kohlenstoff bestehenden Passivierungsschicht 22 versehen worden sind.

### Vergleichsbeispiel 1 (Vergleichsprodukt)

Als Vergleichsbeispiel 1 wurden mit dem Vorprodukt gemäß Ausführungsbeispiel 1 identische Hochleistungs-Diodenlaser hergestellt, deren Spaltflächen wie vorstehend erläutert gereinigt und mit einer aus Silicium und Kohlenstoff bestehenden Passivierungsschicht 22 versehen wurden, deren optische Funktionsschichten jedoch abweichend von dem Verfahren gemäß der vorliegenden Erfindung an der Auskoppelfacette aus Silicium und Stickstoff und an der Spiegelfacette aus einem Doppelpärchen von Silicium und Siliciumdioxid bestehen und die jeweils in einer separaten Sputteranlage aufgebracht worden sind.

### Ausführungsbeispiel 2 (Endprodukt)

Ein Vorprodukt gemäß Ausführungsbeispiel 1 wurde fertigprozessiert, indem auf die die Passivierungsschichten 22 Funktionsschichten 24 aufgebracht worden sind, die gemäß der Erfindung aus Silicium und Kohlenstoff aufgebaut sind.

### Vergleichsbeispiel 2

In einem Vergleichsbeispiel wurden Hochleistungs-Diodenlaser mit einer Facettenbeschichtung mittels einer Sputteranlage gemäß dem Stand der Technik hergestellt. Die Reinigung der Spaltflächen erfolgte durch einen Ar-Flash der Leistung 600W. Die optischen Funktionsschichten bestehen aus Silicium und Stickstoff an der Auskoppelfacette und einem Doppelpärchen von Silicium und Siliciumdioxid an der Spiegelfacette, wobei auf die gereinigten Spaltflächen keine Passivierungsschicht aufgebracht worden ist.

Sowohl in den Ausführungsbeispielen 1 und 2 als auch bei den Vergleichsbeispielen 1 und 2 hatten die Hochleistungs-Diodenlaser eine Resonatorlänge von 4000 µm und eine Streifenbreite von 90 µm.

Hochleistungs-Diodenlaser aus allen vier Herstellungsverfahren sind einem Belastungstest unterzogen worden. Dabei wurde bei einer Temperatur von 20°C mit einer Pulslänge von 50ps und einer Wiederholrate von 50Hz der Strom bis auf 40A hochgefahren.

Im Diagramm gemäß Fig. 2 ist in Kurve a die optische Ausgangsleistung P gegen den Betriebsstrom I für einen gepulst betriebenen Hochleistungs-Diodenlaser aufgetragen, der nicht mit einem Schichtsystem versehen ist (as cleaved). Kurven b und c sind mit einem gemäß Ausführungsbeispiel 1 hergestellten, nicht fertigprozessierten Hochleistungs-Diodenlaser unter kontinuierlichen (Kurve b) bzw. gepulsten Betriebsbedingungen (Kurve c) erzeugt. Dem Diagramm ist zu entnehmen, dass das Vorprodukt gemäß Ausführungsbeispiel 1 im Pulsbetrieb eine vierfach höhere Maximalleistung zeigt als ein nicht mit einem Schichtsystem versehener Hochleistungs-Diodenlaser. Zudem zeigt der gemäß Ausführungsbeispiel 1 (Vorprodukt) hergestellte Hochleistungs-Diodenlaser selbst bei 40A im Gegensatz zu dem as-cleaved-Diodenlaser keinen COD-Ausfall der Facette. Auch im kontinuierlichen Betrieb konnte bis 20A kein COD-Ausfall beobachtet werden.

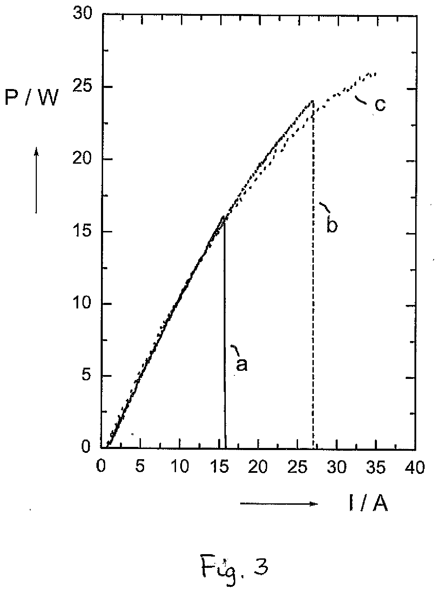

Im Diagramm der Fig. 3 ist in Kurven a, b und c die Ausgangsleistung P gegen den Betriebsstrom I für die Vergleichsbeispiele 2 (Kurve a) bzw. 1 (Kurve b), bzw. dem fertigprozessierten Ausführungsbeispiel 2 (Kurve c) jeweils unter gepulsten Betriebsbedingungen dargestellt. Während bei dem gemäß Vergleichsbeispiel 2 hergestellten Hochleistungs-Diodenlaser eine maximale Leistung von 16 W bei einem Betriebsstrom von 15,4 A gemessen wurde, konnte bei den gemäß Vergleichsbeispiel 1 hergestellten Hochleistungs-Diodenlasern eine maximale Leistung von 24W und bei den gemäß Ausführungsbeispiel hergestellten Hochleistungs-Diodenlasern eine maximale Leistung von 26 bis 27W bei einem Betriebsstrom von 35 bis 37A gemessen werden.

Daraus folgt, dass das Aufbringen von aus Silicium und Kohlenstoff bestehenden Schichtsystemen auf die vorher gereinigten Spaltflächen unabhängig von den danach aufgebrachten optischen Funktionsschichten deutlich höhere optische Leistungsdichten auf den Facetten ermöglicht als bei Facetten, die mit herkömmlichen Verfahren hergestellt worden sind. Auch ist dieses aus Silizium und Kohlenstoff bestehende Schichtsystem stabil gegenüber nachträglich mittels Sputteranlagen aufgebrachten Schichten.

Für die Langzeitstabilität der Laserdioden ist die Dichtigkeit und die chemische Langzeitstabilität der Schichtsysteme auf den Laserfacetten verantwortlich.

In einem weiteren Funktionstest wurden Breitstreifen-Hochleistungs-Diodenlaser, die gemäß Ausführungsbeispiel 2 und gemäß Vergleichsbeispiel 2 hergestellt worden sind, einem Alterungstest unterzogen. Während des Tests, der 2500 Stunden bei einer Temperatur von 30°C durchgeführt wurde, wurden die Dioden bei einem festen Betriebsstrom stabilisiert. Nach einer gewissen Betriebsdauer wurde der Betriebsstrom um einen festen Betrag erhöht und wieder stabilisiert.

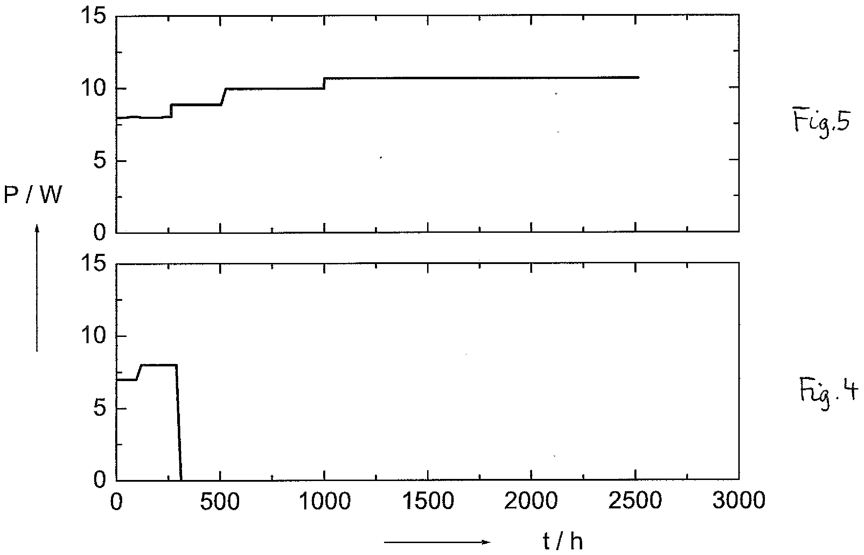

In den Diagrammen der Fig. 4 und 5 ist die jeweilige optische Ausgangsleistung P gegen die Betriebsdauer t aufgetragen. Fig. 4 zeigt den zeitlichen Verlauf der Ausgangsleistung P für einen gemäß Vergleichsbeispiel 2 hergestellten Hochleistungs-Diodenlaser. Fig. 5 zeigt den zeitlichen Verlauf der Ausgangsleistung P für einen gemäß Ausführungsbeispiel 2 hergestellten Hochleistungs-Diodenlaser. Während der gemäß Vergleichsbeispiel 2 hergestellte Hochleistungs-Diodenlaser bereits nach wenigen 100 Stunden ausfiel, zeigte der gemäß Ausführungsbeispiel 2 hergestellte Hochleistungs-Diodenlaser keine sichtbare Degradation, obwohl die optische Ausgangsleistung schrittweise erhöht worden ist. Dies zeigt die gute Langzeitstabilität der aus Silizium und Kohlenstoff bestehenden Schichtsysteme.

## Patentansprüche

1. Hochleistungs-Diodenlaser mit einander gegenüberliegenden Facetten, die jeweils aus einem mehrere aus Silicium und Kohlenstoff zusammengesetzte amorphe Schichten (22, 24) umfassendes Schichtsystem (26, 28) aufgebaut sind, das sowohl eine Passivierungsschicht (22) als auch mehrere, die Reflexion bestimmende Funktionsschichten (24) enthält,
wobei die Brechungsindizes der Passivierungsschicht (22) und der Funktionsschichten (24) über einen variierenden Kohlenstoffgehalt eingestellt sind.

2. Verfahren zum Herstellen eines Hochleistungs-Diodenlasers nach Anspruch 1, bei dem auf dessen einander gegenüberliegenden Spaltflächen (18,20) jeweils ein mehrere aus Silicium und Kohlenstoff zusammengesetzte amorphe Schichten (22, 24) umfassendes Schichtsystem (26, 28) mit einem CVD-Verfahren, insbesondere mit einem PECVD-Verfahren abgeschieden wird, das sowohl eine Passivierungsschicht (22) als auch mehrere, die Reflexion bestimmende Funktionsschichten (24) enthält,
wobei die Brechungsindizes der Passivierungsschicht (22) und der Fuktionsschichten (24) über eine Variation des Kohlenstoffgehalts während des Abscheidens eingestellt werden.

3. Verfahren nach Anspruch 2, bei dem die Spaltflächen (18,20) vor dem Aufbringen des Schichtsystemes (26, 28) höchstens unter Hochvakuum mittels Plasmaverfahren unter Verwendung eines Formiergases gereinigt werden.

4. Verfahren nach Anspruch 3, bei dem als Formiergas Argon und/oder Wasserstoff verwendet wird, dessen Teilchen kinetische Energien haben, die kleiner als 20eV sind.

5. Verfahren nach einem der Ansprüche 2 bis 4, bei dem als Prozessgase für die Abscheidung Methan, CH₄, und Silan, SiH₄, verwendet werden.

6. Verfahren nach einem der Ansprüche 2 bis 5, bei dem das aus Silicium und Kohlenstoff bestehende Schichtsystem (26, 28) in derselben Prozesskammer aufgebracht wird.

## Claims

1. High-power diode laser having facets opposing one another which are respectively constructed from a layer system (26, 28) comprising several amorphous layers (22, 24) composed of silicon and carbon, said layer system (26, 28) containing both a passivation layer (22) and several functional layers (24), said functional layers (24) determining the reflection,
wherein the refractive indices of the passivation layer (22) and the functional layers (24) are set via a varying carbon content.

2. Method for producing a high-power diode laser according to claim 1, in which a layer system (26, 28) comprising several amorphous layers (22, 24) composed of silicon and carbon is respectively deposited on the cleavage faces (18, 20) of said diode laser, said cleavage faces (18, 20) opposing one another, by a CVD method, in particular by a PECVD method, said layer system (26, 28) containing both a passivation layer (22) and several functional layers (24), said functional layers (24) determining the reflection, wherein the refractive indices of the passivation layer (22) and the functional layers (24) are set via a variation in the carbon content during the deposition.

3. Method according to claim 2, in which the cleavage faces (18, 20) are purified, at the most under a high vacuum, by means of plasma processing using a forming gas, before the application of the layer system (26, 28).

4. Method according to claim 3, in which argon and/or hydrogen is used as the forming gas, whose particles have kinetic energies smaller than 20eV.

5. Method according to one of claims 2 to 4, in which methane, CH₄, and silane, SiH₄, are used as the process gases for the deposition.

6. Method according to one of claims 2 to 5, in which the layer system (26, 28) consisting of silicon and carbon is applied in the same process chamber.

## Revendications

1. Laser à diodes de grande puissance, ayant des facettes opposées l'une à l'autre, qui sont constituées chacune d'un système (26, 28) stratifié, comprenant plusieurs couches (22, 24) amorphes composées de silicium et de carbone, qui contient à la fois une couche (22) de passivation et plusieurs couches (24) fonctionnelles déterminant la réflexion, les indices de réfraction de la couche (22) de passivation et des couches (24) fonctionnelles étant réglés par une teneur variable en carbone.

2. Procédé de fabrication d'un laser à diodes de grande puissance suivant la revendication 1, dans lequel on dépose, par un procédé CVD, notamment par un procédé PECVD, sur ses faces (18, 20) de clivage opposées l'une à l'autre, respectivement un système (26, 28) stratifié, comprenant plusieurs couches (22, 24) amorphes composées de silicium et de carbone, qui contient à la fois une couche (22) de passivation et plusieurs couches (24) fonctionnelles déterminant la réflexion,
dans lequel on règle les indices de réfraction de la couche (22) de passivation et des couches (24) fonctionnelles par une variation de la teneur en carbone pendant le dépôt.

3. Procédé suivant la revendication 2, dans lequel on nettoie à fond, sous un vide poussé au moyen d'un procédé au plasma en utilisant un gaz de formage, les surfaces (18, 20) de clivage avant le dépôt du système (26, 28) stratifié.

4. Procédé suivant la revendication 3, dans lequel on utilise, comme gaz de formage, de l'argon et/ou de l'hydrogène, dont les particules ont une énergie cinétique plus petite que 20eV.

5. Procédé suivant l'une des revendications 2 à 4, dans lequel on utilise, comme gaz de processus pour le dépôt, du méthane, CH_{4'} et du silane, SiH_{4'}.

6. Procédé suivant l'une des revendications 2 à 5, dans lequel on dépose, dans la même chambre de processus, le système (26, 28) stratifié constitué de silicium et de carbone.
